# EUROPEAN PATENT APPLICATION

(11) **EP 2 999 323 A1**
(43) Date of publication of application: **23.03.2016**
(21) Application number: 15181782.2
(22) Date of filing: 20.08.2015
(51) Int. Cl.: H05K 7/20

(54) **FAN CONTROL METHOD AND NETWORK DEVICE**

(30) Priority: 16.09.2014 CN 201410472989
(71) Applicant: Huawei Technologies Co., Ltd., Longgang District Shenzhen, Guangdong 518129 (CN)
(72) Inventor: ZHU, Sihai, 518129, P.R. Shenzhen (CN)
(74) Representative: Gill Jennings & Every LLP

(57) **Abstract**

A fan control method and a network device are disclosed. The method includes: acquiring a temperature of a target position in the network device; determining, according to the temperature of the target position, that one air duct in a first air duct corresponding to a first air vent of the network device and a second air duct corresponding to a second air vent of the network device is a cold air duct, and that the other air duct is a hot air duct, where the first air vent and the second air vent are air vents for heat dissipation disposed for the network device in advance; and setting a rotation direction of a fan of the network device, so that cold air is inhaled from an air vent corresponding to the cold air duct, and hot air is exhausted from an air vent corresponding to the hot air duct.

## Description

### TECHNICAL FIELD

The present invention relates to the field of control technologies, and in particular, to a fan control method and a network device.

### BACKGROUND

During working, a network device needs to work within a temperature range. For example, most network devices of a data center equipment room need to work at an ambient temperature between 0°C and 45°C. If an ambient temperature of the equipment room is lower than 0°C or higher than 45°C, service lives of the network devices are greatly shortened, and the network devices even cannot continue working. Therefore, as performance of network devices is constantly improved, the network devices have an increasingly high requirement for heat dissipation. To effectively dissipate heat, a heat dissipation system of the data center equipment room can implement heat dissipation by planning cold and hot air ducts. When a network device is deployed, a rotation direction of a fan needs to be adjusted according to the cold and hot air ducts, and it is finally implemented that cold air is inhaled through the cold air duct, and hot air is exhausted through the hot air duct.

Currently, when a network device is deployed, to implement that cold air is inhaled through a cold air duct, and hot air is exhausted through a hot air duct, two types of fans having two different rotation directions need to be provided for each network device for selection. When a fan is installed for a network device on site, the fan is determined according to positions of the cold and hot air ducts and rotation direction of the fan. However, an error easily occurs in this fan installation process. When all fans on the network device are incorrectly installed, the network device cannot detect an error, and as a result, cold air is inhaled through the hot air duct, and hot air is exhausted through the cold air duct. When some fans are incorrectly installed, after detecting that rotation directions of fans conflict, the network device adjusts all fans in a direction in which more fans rotate to a full speed, and adjusts other remaining fans to a minimum rotation speed or stops rotation of the other remaining fans (where if quantities of fans rotating in two directions are equal, fans in one direction are randomly selected and adjusted to a full speed, and the other fans are adjusted to a minimum rotation speed or rotation of the other fans is stopped), which may also finally cause that cold air is inhaled through the hot air duct, and hot air is exhausted through the cold air duct. As can be seen, in the existing manner, two types of fans having two different rotation directions needs to be provided for each network device, and production costs are high; fan installation is extremely error-prone, which not only affects heat dissipation of a network device on which a fan is located, but also may adversely affect heat dissipation of other surrounding network devices; and if a network device is migrated, a cold air duct and a hot air duct before and behind the network device change, and fans of the network device need to be changed, which increases fan installation and maintenance costs.

### SUMMARY

To resolve the foregoing problems, the present invention provides a fan control method and a network device, which can automatically and intelligently adjust a rotation direction of a fan in a network device, and implement self-adaptation of the rotation direction of the fan to an air duct environment.

According to a first aspect, the present invention provides a fan control method, applied to a network device, and including:
acquiring a temperature of a target position in the network device;
determining, according to the temperature of the target position, that one air duct in a first air duct corresponding to a first air vent of the network device and a second air duct corresponding to a second air vent of the network device is a cold air duct, and that the other air duct is a hot air duct, where the first air vent and the second air vent are air vents for heat dissipation disposed for the network device in advance; and
setting a rotation direction of a fan of the network device, so that cold air is inhaled from an air vent corresponding to the cold air duct, and hot air is exhausted from an air vent corresponding to the hot air duct.

With reference to the first aspect, in a first possible implementation manner, a first temperature sensor for measuring a temperature of the first air vent and a second temperature sensor for measuring a temperature of the second air vent are disposed in advance in the network device; and
the acquiring a temperature of a target position in the network device includes:
respectively acquiring a first temperature value of the first air vent of the network device and a second temperature value of the second air vent of the network device by using the first temperature sensor and the second temperature sensor.

With reference to the first possible implementation manner of the first aspect, in a second possible implementation manner, the respectively acquiring a first temperature value of the first air vent of the network device and a second temperature value of the second air vent of the network device includes:
when the rotation direction of the fan enables that cold air is inhaled from the first air vent, and hot air is exhausted from the second air vent, acquiring the first temperature value indicated by the first temperature sensor; and
when the rotation direction of the fan enables that cold air is inhaled from the second air vent, and hot air is exhausted from the first air vent, acquiring the second temperature value indicated by the second temperature sensor.

With reference to the first aspect, in a third possible implementation manner, a temperature sensor for measuring the temperature of the target position is disposed in advance in the network device; and
the acquiring a temperature of a target position in the network device includes:
when the rotation direction of the fan enables that cold air is inhaled from the first air vent, and hot air is exhausted from the second air vent, acquiring a first temperature value of the network device by using the temperature sensor that is disposed in advance; and
when the rotation direction of the fan enables that cold air is inhaled from the second air vent, and hot air is exhausted from the first air vent, acquiring a second temperature value of the network device by using the temperature sensor that is disposed in advance.

With reference to the first possible implementation manner of the first aspect, or the second possible implementation manner of the first aspect, or the third possible implementation manner of the first aspect, in a fourth possible implementation manner, the determining, according to the temperature of the target position, that one air duct in a first air duct corresponding to a first air vent of the network device and a second air duct corresponding to a second air vent of the network device is a cold air duct, and that the other air duct is a hot air duct includes:
comparing the first temperature value with the second temperature value; and
if the first temperature value is less than the second temperature value, determining that the first air duct is a cold air duct, and determining that the second air duct is a hot air duct; or
if the first temperature value is greater than the second temperature value, determining that the second air duct is a cold air duct, and determining that the first air duct is a hot air duct.

According to a second aspect, the present invention further provides a network device, including: a processor, a fan, a first air vent, a second air vent, and at least one temperature sensor, where the first air vent corresponds to a first air duct, the second air vent corresponds to a second air duct, and the first air vent and the second air vent are air vents for heat dissipation disposed for the network device in advance; and
the processor is configured to:
acquire a temperature of a target position in the network device by using the at least one temperature sensor;
according to the temperature of the target position, determine that one air duct in the first air duct and the second air duct is a cold air duct, and determine that the other air duct is a hot air duct; and
set a rotation direction of the fan of the network device, so that cold air is inhaled from an air vent corresponding to the cold air duct, and hot air is exhausted from an air vent corresponding to the hot air duct.

With reference to the second aspect, in a first possible implementation manner, the at least one temperature sensor includes a first temperature sensor for measuring a temperature of the first air vent and a second temperature sensor for measuring a temperature of the second air vent; and
when performing the acquiring a temperature of a target position in the network device by using the at least one temperature sensor, the processor is specifically configured to:
respectively acquire a first temperature value of the first air vent of the network device and a second temperature value of the second air vent of the network device by using the first temperature sensor and the second temperature sensor.

With reference to the first possible implementation manner of the second aspect, in a second possible implementation manner, when performing the respectively acquiring a first temperature value of the first air vent of the network device and a second temperature value of the second air vent of the network device by using the first temperature sensor and the second temperature sensor, the processor is specifically configured to:
when the rotation direction of the fan enables that cold air is inhaled from the first air vent, and hot air is exhausted from the second air vent, acquire, by using the first temperature sensor, the first temperature value indicated by the first temperature sensor; and
when the rotation direction of the fan enables that cold air is inhaled from the second air vent, and hot air is exhausted from the first air vent, acquire, by using the second temperature sensor, the second temperature value indicated by the second temperature sensor.

With reference to the second aspect, in a third possible implementation manner, the at least one temperature sensor is disposed at the target position in the network device; and
when performing the acquiring a temperature of a target position in the network device by using the at least one temperature sensor, the processor is configured to:
when the rotation direction of the fan enables that cold air is inhaled from the first air vent, and hot air is exhausted from the second air vent, acquire a first temperature value of the network device by using the at least one temperature sensor; and
when the rotation direction of the fan enables that cold air is inhaled from the second air vent, and hot air is exhausted from the first air vent, acquire a second temperature value of the network device by using the at least one temperature sensor.

With reference to the first possible implementation manner of the second aspect, or the second possible implementation manner of the second aspect, or the third possible implementation manner of the second aspect, in a fourth possible implementation manner, when performing the determining, according to the temperature of the target position, that one air duct in the first air duct and the second air duct is a cold air duct, and that the other air duct is a hot air duct, the processor is specifically configured to:
compare the first temperature value with the second temperature value; and
if the first temperature value is less than the second temperature value, determine that the first air duct is a cold air duct, and determine that the second air duct is a hot air duct; or
if the first temperature value is greater than the second temperature value, determine that the second air duct is a cold air duct, and determine that the first air duct is a hot air duct.

In the present invention, a cold air duct and a hot air duct in air ducts corresponding to air vents of a network device can be determined by detecting a temperature of a target position in the network device. In this way, a rotation direction of a fan in the network device is automatically and intelligently adjusted, so that the rotation direction of the fan enables that cold air is inhaled from an air vent corresponding to the cold air duct, and hot air is exhausted from an air vent corresponding to the hot air duct. Therefore, self-adaptive adjustment of the rotation direction of the fan to an air duct environment is implemented, and fan installation and maintenance costs are reduced.

### BRIEF DESCRIPTION OF DRAWINGS

To describe the technical solutions in the embodiments of the present invention more clearly, the following briefly introduces the accompanying drawings required for describing the embodiments. Apparently, the accompanying drawings in the following description show merely some embodiments of the present invention, and persons of ordinary skill in the art may still derive other drawings from these accompanying drawings without creative efforts.
FIG. 1 is a schematic diagram of a deployment environment of a network device according to an embodiment of the present invention;
FIG. 2 is a schematic flowchart of a fan control method according to an embodiment of the present invention;
FIG. 3 is a schematic diagram of an application scenario of FIG. 2;
FIG. 4 is a schematic diagram of another application scenario of FIG. 2;
FIG. 5 is a schematic structural diagram of a fan control apparatus according to an embodiment of the present invention;
FIG. 6 is a schematic structural diagram of another fan control apparatus according to an embodiment of the present invention; and
FIG. 7 is a schematic structural diagram of a network device according to an embodiment of the present invention.

### DESCRIPTION OF EMBODIMENTS

The following clearly and completely describes the technical solutions in the embodiments of the present invention with reference to the accompanying drawings in the embodiments of the present invention. Apparently, the described embodiments are merely some but not all of the embodiments of the present invention. All other embodiments obtained by persons of ordinary skill in the art based on the embodiments of the present invention without creative efforts shall fall within the protection scope of the present invention.

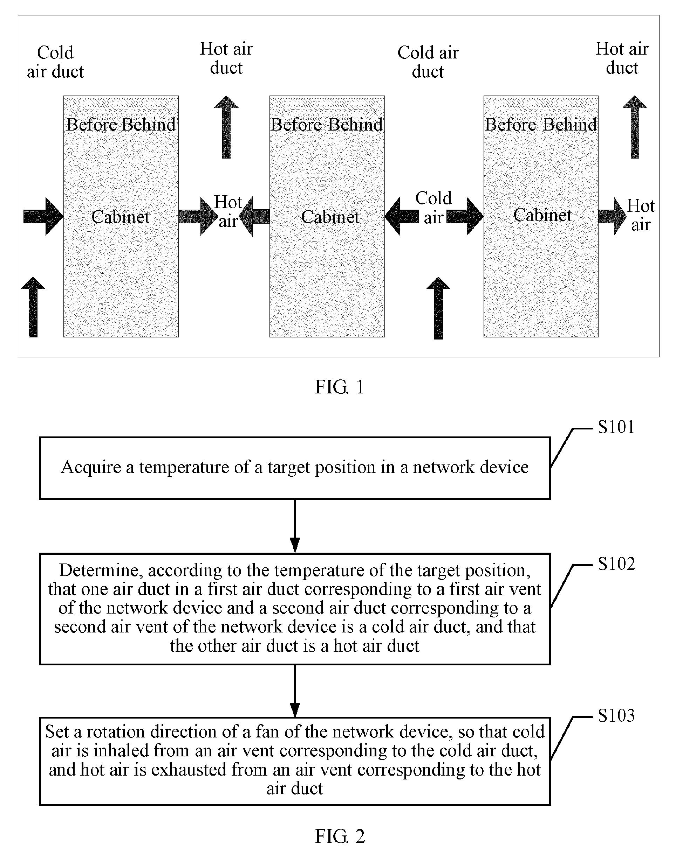

When a fan is installed on a network device, the fan needs to be installed according to cold and hot air ducts deployed in an equipment room. As shown in FIG. 1, which is a schematic diagram of a deployment environment of a network device according to an embodiment of the present invention, after a network device is deployed in a cabinet, when a fan is installed for the network device, a rotation direction of the fan needs to be adjusted according to designed positions of cold and hot air ducts, and it is finally implemented that cold air is inhaled from an air vent corresponding to the cold air duct, and hot air is exhausted from an air vent corresponding to the hot air duct.

Refer to FIG. 2, which is a schematic flowchart of a fan control method according to an embodiment of the present invention. The method may be specifically applied to a network device. Specifically, the method in this embodiment of the present invention includes:
S101: Acquire a temperature of a target position in the network device.

In a specific embodiment, the acquired temperature of the target position may be specifically a temperature of an air vent of the network device, or a temperature of a key chip in the network device, which is not limited in this embodiment of the present invention.

Optionally, temperature sensors may be separately disposed at the target positions in the network device in advance, for example, a first air vent and a second air vent of the network device, and a first temperature value of the first air vent of the network device and a second temperature value of the second air vent of the network device are separately acquired by using the temperature sensors.

Specifically, when a rotation direction of a fan of the network device causes that cold air is inhaled into the network device from the first air vent, and hot air is exhausted from the second air vent, the first temperature value indicated by a temperature sensor of the first air vent may be acquired; when the rotation direction of the fan enables that cold air is inhaled from the second air vent, and hot air is exhausted from the first air vent, the second temperature value indicated by a temperature sensor of the second air vent may be acquired. In this way, the first temperature value of the first air vent of the network device and the second temperature value of the second air vent of the network device are acquired.

Optionally, a temperature sensor may be disposed at the target position in the network device in advance, for example, at the key chip inside the network device, and temperatures indicated by the temperature sensor when the fan rotates in different directions are detected by using the disposed temperature sensor. Specifically, when a rotation direction of the fan of the network device enables that cold air is inhaled into the network device from the first air vent, and hot air is exhausted from the second air vent, a first temperature value of the network device may be acquired by using the temperature sensor that is disposed in advance; and when the rotation direction of the fan enables that cold air is inhaled from the second air vent, and hot air is exhausted from the first air vent, a second temperature value of the network device may be acquired by using the temperature sensor that is disposed in advance.

S102: Determine, according to the temperature of the target position, that one air duct in a first air duct corresponding to a first air vent of the network device and a second air duct corresponding to a second air vent of the network device is a cold air duct, and that the other air duct is a hot air duct.

It should be noted that the first air vent and the second air vent are air vents for heat dissipation disposed for the network device in advance; and one air duct in the first air duct corresponding to the first air vent and the second air duct corresponding to the second air vent is a cold air duct, and the other air duct is a hot air duct.

In a specific embodiment, when the cold air duct and hot air duct are determined in the air ducts corresponding to the first air vent and the second air vent of the network device, the acquired first temperature value and the acquired second temperature value of the target position of the network device may be compared. If the first temperature value is less than the second temperature value, it is determined that the first air duct corresponding to the first air vent is a cold air duct, and it is determined that the second air duct corresponding to the second air vent is a hot air duct; or if the first temperature value is greater than the second temperature value, it is determined that the second air duct is a cold air duct, and it is determined that the first air duct is a hot air duct.

S103: Set a rotation direction of a fan of the network device, so that cold air is inhaled from an air vent corresponding to the cold air duct, and hot air is exhausted from an air vent corresponding to the hot air duct.

In a specific embodiment, during determining the air ducts separately corresponding to the first air vent and the second air vent of the network device, the rotation direction of the fan may be adjusted, so that cold air is inhaled from the air vent corresponding to the cold air duct, and hot air is exhausted from the air vent corresponding to the hot air duct. In this way, the rotation direction of the installed fan is determined. Specifically, if it is determined that the first air duct corresponding to the first air vent is a cold air duct, and the second air duct corresponding to the second air vent is a hot air duct, it indicates that the first air vent is an air inlet from which cold air is inhaled, and the second air vent is an air outlet from which hot air is exhausted; and the rotation direction of the fan may be adjusted, so that cold air is inhaled from the first air vent, and hot air is exhausted from the second air vent. If it is determined that the second air duct is a cold air duct, and the first air duct is a hot air duct, the rotation direction of the fan may be adjusted, so that the rotation direction of the fan enables that cold air is inhaled from the second air vent, and hot air is exhausted from the first air vent.

In this embodiment of the present invention, a cold air duct and a hot air duct in air ducts corresponding to air vents of a network device can be determined by detecting a temperature of a target position in the network device. In this way, a rotation direction of a fan in the network device is automatically and intelligently adjusted, so that the rotation direction of the fan enables that cold air is inhaled from an air vent corresponding to the cold air duct, and hot air is exhausted from an air vent corresponding to the hot air duct. Therefore, self-adaptive adjustment of the rotation direction of the fan to an air duct environment is implemented, and fan installation and maintenance costs are reduced.

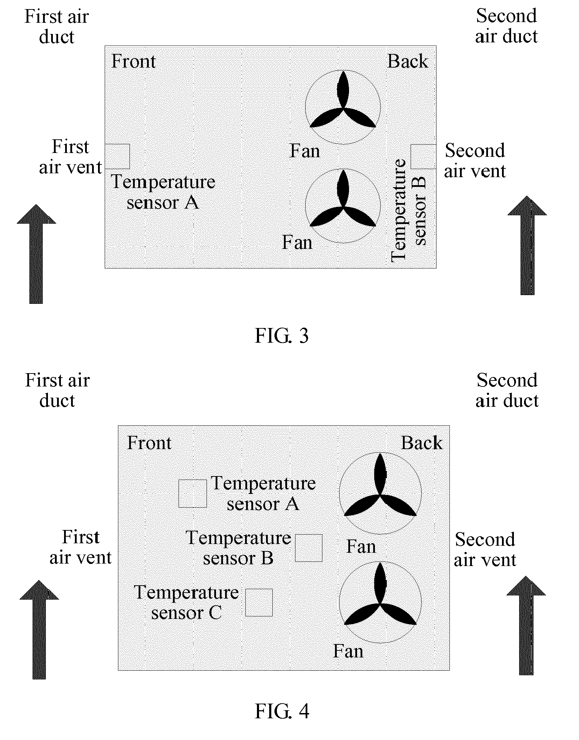

Further, refer to FIG. 3, which is a schematic diagram of an application scenario of FIG. 2. As shown in FIG. 3, the first temperature sensor for measuring a temperature of the first air vent, that is, a temperature sensor A, is disposed at the first air vent of the network device, and the second temperature sensor for measuring a temperature of the second air vent, that is, a temperature sensor B, is disposed at the second air vent. One air duct in the first air duct corresponding to the first air vent and the second air duct corresponding to the second air vent is a cold air duct, and the other air vent is a hot air duct (where it is assumed that the air ducts are deployed before and behind the network device; and an air vent disposed in the front of the network device is used as the first air vent, and an air vent disposed in the back of the network device is used as the second air vent), that is, one air vent in the first air vent and the second air vent is an air inlet from which cold air is inhaled, and the other air vent is an air outlet from which hot air is exhausted. Specifically, the air vent corresponding to the cold air duct is the air inlet from which cold air is inhaled.

Specifically, after the network device is powered on and runs for a period of time, the first temperature value of the first air vent may be acquired by using the temperature sensor A disposed at the first air vent, and the second temperature value of the second air vent may be acquired by using the temperature sensor B disposed at the second air vent. The first temperature value and the second temperature value are compared. When the first temperature value is less than the second temperature value, it may indicate that the first air duct is a cold air duct, and the second air duct is a hot air duct; or when the first temperature value is greater than the second temperature value, it may indicate that the second air duct is a cold air duct, and the first air duct is a hot air duct. If the first temperature value is equal to the second temperature value, it may indicate that the cold and hot air ducts are indeterminate in a current equipment room environment; and a current rotation direction of the fan may be maintained, or the fan may be adjusted to any rotation direction, which is not limited in this embodiment of the present invention.

Optionally, to acquire ambient temperatures at the first air vent and the second air vent more accurately, when the first temperature value at the first air vent and the second temperature value at the second air vent are respectively acquired by using the temperature sensor A and the temperature sensor B, the fan may further be first controlled to rotate in different directions (where the rotation directions include a direction in which cold air is inhaled from the first air vent and hot air is exhausted from the second air vent, and a direction in which cold air is inhaled from the second air vent and hot air is exhausted from the first air vent). When a rotation direction of the fan enables that cold air is inhaled from the first air vent, and hot air is exhausted from the second air vent, the rotation direction of the fan is maintained, and after a temperature value indicated by the temperature sensor at the first air vent, that is, the temperature sensor A is stable, the first temperature value of the temperature sensor A is acquired. When a rotation direction of the fan enables that cold air is inhaled from the second air vent, and hot air is exhausted from the first air vent, the rotation direction of the fan is also maintained, and after a temperature value indicated by the temperature sensor at the second air vent, that is, the temperature sensor B is stable, the second temperature value of the temperature sensor B is acquired. Specifically, a temperature fluctuation threshold may further be preset. When it is determined whether a temperature value indicated by a temperature sensor is stable, if the indicated temperature value does not exceed the preset temperature fluctuation threshold, it may indicate that the temperature value of the temperature sensor is stable, and the stable temperature value is acquired.

Optionally, there may be multiple temperature sensors disposed at the first air vent and/or the second air vent. When the air ducts corresponding to the first air vent and the second air vent are determined by using temperature values of the temperature sensors, average values of temperatures indicated by the multiple temperature sensors may be acquired, and the air ducts corresponding to the air vents of the device may be determined by comparing the average values. For example, if multiple temperature sensors are disposed at the first air vent in advance, an average value of temperatures indicated by the multiple temperature sensors may be used as the first temperature value.

Further and alternatively, a temperature difference threshold may be preset. When a difference between the first temperature value and the second temperature value exceeds the temperature difference threshold, the air ducts corresponding to the first air vent and the second air vent are directly determined by using the first temperature value and the second temperature value that are indicated by the temperature sensor A and the temperature sensor B, without further controlling the fans to rotate in different directions and acquiring the first temperature value and the second temperature value that correspond to the first air vent and the second air vent.

After the air ducts corresponding to the first air vent and the second air vent are determined, the rotation direction of the fans of the network device can be controlled, so that cold air is inhaled from the air vent corresponding to the cold air duct, and hot air is exhausted from the air vent corresponding to the hot air duct.

During implementation of this embodiment of the present invention, ambient temperatures of a first air vent and a second air vent of a network device are separately acquired by temperature sensors that are deployed in advance, so that determining can be performed on air ducts corresponding to the air vents; further, to acquire the ambient temperatures of the first air vent and the second air vent more accurately, the acquired temperatures may be different temperature values after heat dissipation performed in different rotation directions of a fan, so that a cold air duct and a hot air duct in the air ducts corresponding to the air vents of the network device are determined by comparing the different temperature values. In this way, a rotation direction of the fan is automatically and intelligently adjusted, so that the rotation direction of the fan can enable that cold air is inhaled from an air vent corresponding to the cold air duct, and hot air is exhausted from an air vent corresponding to the hot air duct. Therefore, fan installation and maintenance costs are reduced.

Further, refer to FIG. 4, which is a schematic diagram of another application scenario of FIG. 2. As shown in FIG. 4, a temperature sensor is disposed at the key chip inside the network device. Further, there may be multiple disposed temperature sensors. For example, as shown in FIG. 4, three temperature sensors, that is, a temperature sensor A, a temperature sensor B, and a temperature sensor C are disposed. One air duct in the first air duct corresponding to the first air vent and the second air duct corresponding to the second air vent is a cold air duct, and the other air duct is a hot air duct.

Specifically, after the network device is powered on, the fan may be first controlled to rotate in one direction, for example, a rotation direction of the fan is controlled, so that cold air is inhaled from the first air vent, and hot air is exhausted from the second air vent, that is, air is blown from the first air vent to the second air vent; the rotation direction of the fan is maintained; after readings of the temperature sensors are stable, temperature values of the temperature sensor A, the temperature sensor B, and the temperature sensor C are read; and an average value D1 of the three temperature values is further obtained by calculation. Then, the fan is adjusted to rotate in a reverse direction, that is, a rotation direction of the fan is controlled, so that cold air is inhaled from the second air vent, and hot air is exhausted from the first air vent; the rotation direction of the fan is maintained; after readings of the temperature sensors are stable, temperature values of the temperature sensor A, the temperature sensor B, and the temperature sensor C are read; and an average value D2 is further obtained by calculation. D1 and D2 are then compared. If D1 is less than D2, it indicates that the first air duct corresponding to the first air vent is a cold air duct, and the second air duct corresponding to the second air vent is a hot air duct; if D1 is greater than D2, it indicates that the second air duct is a cold air duct, and the first air duct is a hot air duct; or if D1 is equal to D2, it indicates that the cold and hot air ducts are indeterminate in a current equipment room environment, and a current rotation direction of the fan may be maintained, or the fan may be adjusted to any rotation direction, which is not limited in this embodiment of the present invention.

After the cold air duct and the hot air duct are determined, the rotation direction of the fan of the network device can be controlled, so that cold air is inhaled from the air vent corresponding to the cold air duct, and hot air is exhausted from the air vent corresponding to the hot air duct.

In this embodiment of the present invention, a temperature sensor is disposed at a key chip inside a network device in advance, so that temperature values indicated by the temperature sensor after heat dissipation performed in different rotation directions of a fan can be separately acquired. In this way, a cold air duct and a hot air duct in air ducts corresponding to air vents of the network device are determined by comparing the temperature values corresponding to the different rotation directions of the fan, and a rotation direction of the fan is automatically and intelligently adjusted, so that the rotation direction of the fan can enable that cold air is inhaled from an air vent corresponding to the cold air duct, and hot air is exhausted from an air vent corresponding to the hot air duct. Therefore, fan installation and maintenance costs are reduced.

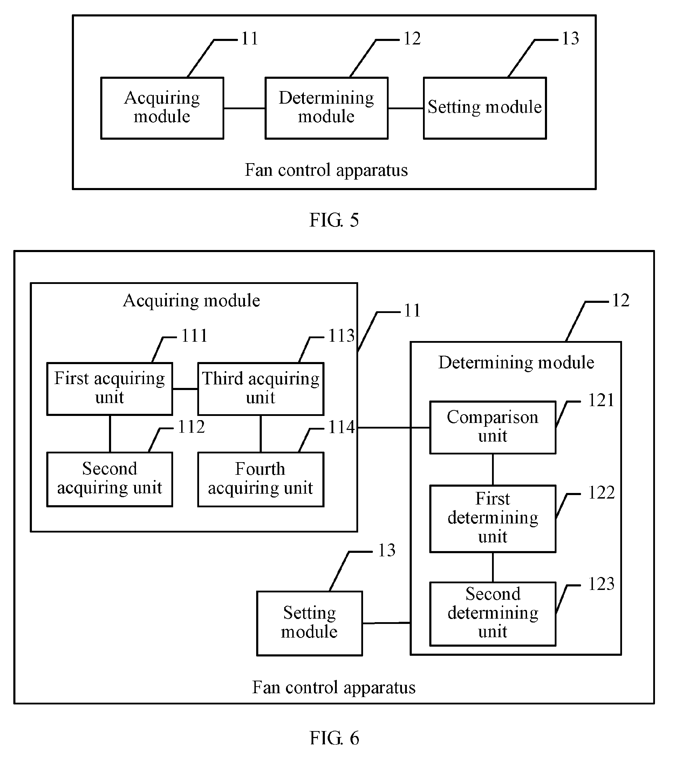

Refer to FIG. 5, which is a schematic structural diagram of a fan control apparatus according to an embodiment of the present invention. The apparatus may be specifically disposed in a network device. Specifically, the apparatus in this embodiment of the present invention includes: an acquiring module 11, a determining module 12, and a setting module 13.

The acquiring module 11 is configured to acquire a temperature of a target position in the network device.

In a specific embodiment, the acquired temperature of the target position may be specifically a temperature of an air vent of the network device, or a temperature of a key chip in the network device, which is not limited in this embodiment of the present invention.

The determining module 12 is configured to determine, according to the temperature, acquired by the acquiring module 11, of the target position, that one air duct in a first air duct corresponding to a first air vent of the network device and a second air duct corresponding to a second air vent of the network device is a cold air duct, and that the other air duct is a hot air duct.

It should be noted that the first air vent and the second air vent are air vents for heat dissipation disposed for the network device in advance; and one air duct in the first air duct corresponding to the first air vent and the second air duct corresponding to the second air vent is a cold air duct, and the other air duct is a hot air duct.

The setting module 13 is configured to set a rotation direction of a fan of the network device, so that cold air is inhaled from an air vent corresponding to the cold air duct, and hot air is exhausted from an air vent corresponding to the hot air duct.

In a specific embodiment, after the determining module 12 determines the cold air duct and the hot air duct from the air ducts separately corresponding to the first air vent and the second air vent of the network device, the setting module 13 may adjust the rotation direction of the fan, so that the rotation direction of the fan can enable that cold air is inhaled from the air vent corresponding to the cold air duct, and hot air is exhausted from the air vent corresponding to the hot air duct, thereby determining the rotation direction of the installed fan. Specifically, if the determining module 12 determines that the first air duct corresponding to the first air vent is a cold air duct, and the second air duct corresponding to the second air vent is a hot air vent, the setting module 13 may adjust the rotation direction of the fan, so that cold air is inhaled from the first air vent, and hot air is exhausted from the second air vent. If the determining module 12 determines that the second air duct is a cold air duct, and the first air duct is a hot air duct, the setting module 13 may adjust the rotation direction of the fan, so that cold air is inhaled from the second air vent, and hot air is exhausted from the first air vent.

In this embodiment of the present invention, a cold air duct and a hot air duct in air ducts corresponding to air vents of a network device can be determined by using an acquired temperature of a target position in the network device. In this way, a rotation direction of a fan in the network device is automatically and intelligently adjusted, so that the rotation direction of the fan enables that cold air is inhaled from an air vent corresponding to the cold air duct, and hot air is exhausted from an air vent corresponding to the hot air duct. Therefore, fan installation and maintenance costs are reduced.

Refer to FIG. 6, which is a schematic structural diagram of another fan control apparatus according to an embodiment of the present invention. The apparatus may be specifically disposed in a network device. Specifically, the apparatus in this embodiment of the present invention includes: an acquiring module 11, a determining module 12, and a setting module 13.

The acquiring module 11 is configured to acquire a temperature of a target position in the network device.

In a specific embodiment, the acquired temperature of the target position may be specifically a temperature of an air vent of the network device, or a temperature of a key chip in the network device, which is not limited in this embodiment of the present invention.

The determining module 12 is configured to determine, according to the temperature, acquired by the acquiring module 11, of the target position, that one air duct in a first air duct corresponding to a first air vent of the network device and a second air duct corresponding to a second air vent of the network device is a cold air duct, and that the other air duct is a hot air duct.

It should be noted that the first air vent and the second air vent are air vents for heat dissipation disposed for the network device in advance; and one air duct in the first air duct corresponding to the first air vent and the second air duct corresponding to the second air vent is a cold air duct, and the other air duct is a hot air duct.

The setting module 13 is configured to set a rotation direction of a fan of the network device, so that cold air is inhaled from an air vent corresponding to the cold air duct, and hot air is exhausted from an air vent corresponding to the hot air duct.

In a specific embodiment, when the determining module 12 determines the cold air duct and the hot air duct in the air ducts separately corresponding to the first air vent and the second air vent of the network device, the setting module 13 may adjust the rotation direction of the fan, so that the rotation direction of the fan can enable that cold air is inhaled from the air vent corresponding to the cold air duct, and hot air is exhausted from the air vent corresponding to the hot air duct, thereby determining the rotation direction of the installed fan.

Optionally, in this embodiment of the present invention, if a first temperature sensor for measuring a temperature of the first air vent and a second temperature sensor for measuring a temperature of the second air vent are disposed in advance in the network device, the acquiring module 11 is specifically configured to:
respectively acquire a first temperature value of the first air vent of the network device and a second temperature value of the second air vent of the network device by using the first temperature sensor and the second temperature sensor.

In a specific embodiment, temperature sensors may be separately disposed at the first air vent and the second air vent of the network device in advance, and the acquiring module 11 may separately acquire the first temperature value of the first air vent of the network device and the second temperature value of the second air vent of the network device by using the temperature sensors.

Optionally, in this embodiment of the present invention, if a first temperature sensor for measuring a temperature of the first air vent and a second temperature sensor for measuring a temperature of the second air vent are disposed in advance in the network device, the acquiring module 11 may include:
a first acquiring unit 111, configured to: when the rotation direction of the fan enables that cold air is inhaled from the first air vent, and hot air is exhausted from the second air vent, acquire the first temperature value indicated by the first temperature sensor; and
a second acquiring unit 112, configured to: when the rotation direction of the fan enables that cold air is inhaled from the second air vent, and hot air is exhausted from the first air vent, acquire the second temperature value indicated by the second temperature sensor.

In a specific embodiment, to acquire the temperatures at the first air vent and the second air vent more accurately, the acquiring module 11 may acquire temperature values that are determined, when the fan rotates in different directions (where the rotation directions include a direction in which cold air is inhaled from the first air vent and hot air is exhausted from the second air vent, and a direction in which cold air is inhaled from the second air vent and hot air is exhausted from the first air vent), by using the first temperature sensor disposed at the first air vent of the network device and the second temperature sensor disposed at the second air vent of the network device. Specifically, when the rotation direction of the fan enables that cold air is inhaled from the first air vent, and hot air is exhausted from the second air vent, the first acquiring unit 111 may acquire, after the temperature value indicated by the first temperature sensor is stable, the first temperature value indicated by the first temperature sensor; when the rotation direction of the fan enables that cold air is inhaled from the second air vent, and hot air is exhausted from the first air vent, the second acquiring unit 112 may acquire, after the temperature value indicated by the second temperature sensor is stable, the second temperature value indicated by the second temperature sensor.

Optionally, in this embodiment of the present invention, a temperature sensor for measuring the temperature of the target position is disposed in advance in the network device, and the acquiring module 11 includes:
a third acquiring unit 113, configured to: when the rotation direction of the fan enables that cold air is inhaled from the first air vent, and hot air is exhausted from the second air vent, acquire a first temperature value of the network device by using the temperature sensor that is disposed in advance; and
a fourth acquiring unit 114, configured to: when the rotation direction of the fan enables that cold air is inhaled from the second air vent, and hot air is exhausted from the first air vent, acquire a second temperature value of the network device by using the temperature sensor that is disposed in advance.

In a specific embodiment, a temperature sensor may be disposed at the target position, for example, at a key chip, in the network device in advance, and the acquiring module 11 may acquire a temperature at the key chip by using the disposed temperature sensor. Specifically, after the network device is powered on, the third acquiring unit 113 may set the rotation direction of the fan, so that cold air is inhaled from the first air vent, and hot air is exhausted from the second air vent; and after a reading of the disposed temperature sensor is stable, read a temperature value, that is, the first temperature value of the temperature sensor. The fourth acquiring unit 114 may then adjust the fan to rotate in a reverse direction, that is, set the rotation direction of the fan, so that air flows from the second air vent to the first air vent; and after a reading of the temperature sensor is stable, read a temperature value, that is, the second temperature value of the temperature sensor.

Further, if there are multiple temperature sensors disposed at the key chip, the first temperature value may be an average value of temperature values separately indicated by the multiple temperature sensors when readings are stable, and the second temperature value may be an average value of temperature values separately indicated by the multiple temperature sensors when readings are stable.

Further optionally, in this embodiment of the present invention, the determining module 12 includes:
a comparison unit 121, configured to compare the first temperature value with the second temperature value;
a first determining unit 122, configured to: when the comparison unit 121 determines that the first temperature value is less than the second temperature value, determine that the first air duct is a cold air duct, and determine that the second air duct is a hot air duct; and
a second determining unit 123, configured to: when the comparison unit 121 determines that the first temperature value is greater than the second temperature value, determine that the second air duct is a cold air duct, and determine that the first air duct is a hot air duct.

In a specific embodiment, the acquired first temperature value and second temperature value may be acquired by using the comparison unit 121, so as to determine the air ducts corresponding to the first air vent and the second air vent. Specifically, if the comparison unit 121 determines that the first temperature value is less than the second temperature value, it may indicate that the first air duct is a cold air duct, and the second air duct is a hot air duct; if the comparison unit 121 determines that the first temperature value is greater than the second temperature value, it may indicate that the second air duct is a cold air duct, and the first air duct is a hot air duct; or if the comparison unit 121 determines that the first temperature value is equal to the second temperature value, it may indicate that the cold and hot air ducts are indeterminate in a current equipment room environment, and a current rotation direction of the fan may be maintained, or the fan may be adjusted to any rotation direction, which is not limited in this embodiment of the present invention.

After the determining module 12 determines the air ducts corresponding to the first air vent and the second air vent, the setting module 13 may set the rotation direction of the fan of the network device, so that cold air is inhaled from the air vent corresponding to the cold air duct, and hot air is exhausted from the air vent corresponding to the hot air duct.

In this embodiment of the present invention, a temperature of a target position in a network device such as temperature values of a first air vent and a second air vent of the network device, or a temperature value of a key chip inside the network device can be acquired by using a temperature sensor that is disposed in advance; further, the temperature values may be further temperature values in heat dissipation performed in different rotation directions of the fan; and a cold air duct and a hot air duct in the air ducts corresponding to the air vents of the network device are determined according to the temperature values. In this way, a rotation direction of the fan in the network device is automatically and intelligently adjusted, so that the rotation direction of the fan can enable that cold air is inhaled from an air vent corresponding to the cold air duct, and hot air is exhausted from an air vent corresponding to the hot air duct. Therefore, fan installation and maintenance costs are reduced.

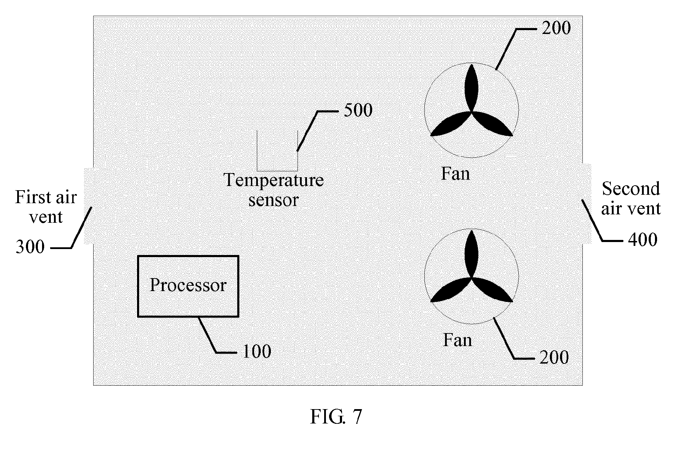

Further, refer to FIG. 7, which is a schematic structural composition diagram of a network device according to an embodiment of the present invention. The network device in this embodiment of the present invention includes: a processor 100, a fan 200, a first air vent 300, a second air vent 400, and at least one temperature sensor 500. One air duct in a first air duct corresponding to the first air vent 300 and a second air duct corresponding to the second air vent 400 is a cold air duct, and the other air duct is a hot air duct. The first air vent 300 and the second air vent 400 are air vents for heat dissipation disposed for the network device in advance.

The processor 100 is configured to perform the following steps:
acquiring a temperature of a target position in the network device by using the at least one temperature sensor 500;
determining, according to the temperature of the target position, that one air duct in the first air duct corresponding to the first air vent 300 of the network device and the second air duct corresponding to the second air vent 400 of the network device is a cold air duct, and that the other air duct is a hot air duct; and
setting a rotation direction of the fan 200 of the network device, so that cold air is inhaled from an air vent corresponding to the cold air duct, and hot air is exhausted from an air vent corresponding to the hot air duct.

Optionally, the at least one temperature sensor 500 includes a first temperature sensor for measuring a temperature of the first air vent 300 and a second temperature sensor for measuring a temperature of the second air vent 400; and
when performing the acquiring a temperature of a target position in the network device by using the at least one temperature sensor 500, the processor 100 specifically performs the following step:
respectively acquiring a first temperature value of the first air vent 300 of the network device and a second temperature value of the second air vent 400 of the network device by using the first temperature sensor and the second temperature sensor.

Optionally, when performing the respectively acquiring a first temperature value of the first air vent 300 of the network device and a second temperature value of the second air vent 400 of the network device by using the first temperature sensor and the second temperature sensor, the processor 100 specifically performs the following steps:
when the rotation direction of the fan 200 enables that cold air is inhaled from the first air vent 300, and hot air is exhausted from the second air vent 400, acquiring, by using the first temperature sensor, the first temperature value indicated by the first temperature sensor; and
when the rotation direction of the fan 200 enables that cold air is inhaled from the second air vent 400, and hot air is exhausted from the first air vent 300, acquiring, by using the second temperature sensor, the second temperature value indicated by the second temperature sensor.

Optionally, the at least one temperature sensor 500 is disposed at the target position in the network device; and
when performing the acquiring a temperature of a target position in the network device by using the at least one temperature sensor 500, the processor 100 specifically performs the following steps:
when the rotation direction of the fan 200 enables that cold air is inhaled from the first air vent 300, and hot air is exhausted from the second air vent 400, acquiring a first temperature value of the network device by using the at least one temperature sensor 500; and
when the rotation direction of the fan 200 enables that cold air is inhaled from the second air vent 400, and hot air is exhausted from the first air vent 300, acquiring a second temperature value of the network device by using the at least one temperature sensor 500.

Optionally, when performing the determining, according to the temperature of the target position, that one air duct in the first air duct corresponding to the first air vent 300 of the network device and the second air duct corresponding to the second air vent 400 of the network device is a cold air duct, and that the other air duct is a hot air duct, the processor 100 specifically performs the following steps:
comparing the first temperature value with the second temperature value; and
if the first temperature value is less than the second temperature value, determining that the first air duct is a cold air duct, and determining that the second air duct is a hot air duct; or
if the first temperature value is greater than the second temperature value, determining that the second air duct is a cold air duct, and determining that the first air duct is a hot air duct.

During implementation of this embodiment of the present invention, a cold air duct and a hot air duct in air ducts corresponding to air vents of a network device can be determined by using an acquired temperature of a target position in the network device. In this way, a rotation direction of a fan in the network device is automatically and intelligently adjusted, so that the rotation direction of the fan enables that cold air is inhaled from an air vent corresponding to the cold air duct, and hot air is exhausted from an air vent corresponding to the hot air duct. Therefore, fan installation and maintenance costs are reduced.

In the several embodiments provided in the present invention, it should be understood that the disclosed apparatus and method may be implemented in other manners. For example, the described apparatus embodiment is merely exemplary. For example, the unit division is merely logical function division and may be other division in actual implementation. For example, a plurality of units or components may be combined or integrated into another system, or some features may be ignored or not performed. In addition, the displayed or discussed mutual couplings or direct couplings or communication connections may be implemented through some interfaces. The indirect couplings or communication connections between the apparatuses or units may be implemented in electrical, mechanical, or other forms.

The units described as separate parts may or may not be physically separate, and parts displayed as units may or may not be physical units, may be located in one position, or may be distributed on a plurality of network units. Some or all of the units may be selected according to actual needs to achieve the objectives of the solutions of the embodiments.

In addition, functional units in the embodiments of the present invention may be integrated into one processing unit, or each of the units may exist alone physically, or two or more units are integrated into one unit. The integrated unit may be implemented in a form of hardware, or may be implemented in a form of hardware in addition to a software functional unit.

When the foregoing integrated unit is implemented in a form of a software functional unit, the integrated unit may be stored in a computer-readable storage medium. The software functional unit is stored in a storage medium and includes several instructions for instructing a computer device (which may be a personal computer, a server, or a network device) or a processor (processor) to perform a part of the steps of the methods described in the embodiments of the present invention. The foregoing storage medium includes: any medium that can store program code, such as a USB flash drive, a removable hard disk, a read-only memory (Read-Only Memory, ROM), a random access memory (Random Access Memory, RAM), a magnetic disk, or an optical disc.

It may be clearly understood by persons skilled in the art that, for the purpose of convenient and brief description, division of the foregoing function modules is used as an example for illustration. In actual application, the foregoing functions can be allocated to different function modules and implemented according to a requirement, that is, an inner structure of an apparatus is divided into different function modules to implement all or part of the functions described above. For a detailed working process of the foregoing apparatus, reference may be made to a corresponding process in the foregoing method embodiments, and details are not described herein again.

Finally, it should be noted that the foregoing embodiments are merely intended for describing the technical solutions of the present invention, but not for limiting the present invention. Although the present invention is described in detail with reference to the foregoing embodiments, persons of ordinary skill in the art should understand that they may still make modifications to the technical solutions described in the foregoing embodiments or make equivalent replacements to some or all technical features thereof, without departing from the scope of the technical solutions of the embodiments of the present invention.

## Claims

1. A fan control method, applied to a network device, and comprising:
acquiring a temperature of a target position in the network device;
determining, according to the temperature of the target position, that one air duct in a first air duct corresponding to a first air vent of the network device and a second air duct corresponding to a second air vent of the network device is a cold air duct, and that the other air duct is a hot air duct, wherein the first air vent and the second air vent are air vents for heat dissipation disposed for the network device in advance; and
setting a rotation direction of a fan of the network device, so that cold air is inhaled from an air vent corresponding to the cold air duct, and hot air is exhausted from an air vent corresponding to the hot air duct.

2. The method according to claim 1, wherein a first temperature sensor for measuring a temperature of the first air vent and a second temperature sensor for measuring a temperature of the second air vent are disposed in advance in the network device; and
the acquiring a temperature of a target position in the network device comprises:
respectively acquiring a first temperature value of the first air vent of the network device and a second temperature value of the second air vent of the network device by using the first temperature sensor and the second temperature sensor.

3. The method according to claim 2, wherein the respectively acquiring a first temperature value of the first air vent of the network device and a second temperature value of the second air vent of the network device comprises:
when the rotation direction of the fan enables that cold air is inhaled from the first air vent, and hot air is exhausted from the second air vent, acquiring the first temperature value indicated by the first temperature sensor; and
when the rotation direction of the fan enables that cold air is inhaled from the second air vent, and hot air is exhausted from the first air vent, acquiring the second temperature value indicated by the second temperature sensor.

4. The method according to claim 1, wherein a temperature sensor for measuring the temperature of the target position is disposed in advance in the network device; and
the acquiring a temperature of a target position in the network device comprises:
when the rotation direction of the fan enables that cold air is inhaled from the first air vent, and hot air is exhausted from the second air vent, acquiring a first temperature value of the network device by using the temperature sensor that is disposed in advance; and
when the rotation direction of the fan enables that cold air is inhaled from the second air vent, and hot air is exhausted from the first air vent, acquiring a second temperature value of the network device by using the temperature sensor that is disposed in advance.

5. The method according to any one of claims 2 to 4, wherein the determining, according to the temperature of the target position, that one air duct in a first air duct corresponding to a first air vent of the network device and a second air duct corresponding to a second air vent of the network device is a cold air duct, and that the other air duct is a hot air duct comprises:
comparing the first temperature value with the second temperature value; and
if the first temperature value is less than the second temperature value, determining that the first air duct is a cold air duct, and determining that the second air duct is a hot air duct; or
if the first temperature value is greater than the second temperature value, determining that the second air duct is a cold air duct, and determining that the first air duct is a hot air duct.

6. A network device, comprising: a processor, a fan, a first air vent, a second air vent, and at least one temperature sensor, wherein the first air vent corresponds to a first air duct, the second air vent corresponds to a second air duct, and the first air vent and the second air vent are air vents for heat dissipation disposed for the network device in advance; and
the processor is configured to:
acquire a temperature of a target position in the network device by using the at least one temperature sensor;
determine, according to the temperature of the target position, that one air duct in the first air duct and the second air duct is a cold air duct, and that the other air duct is a hot air duct; and
set a rotation direction of the fan of the network device, so that cold air is inhaled from an air vent corresponding to the cold air duct, and hot air is exhausted from an air vent corresponding to the hot air duct.

7. The network device according to claim 6, wherein the at least one temperature sensor comprises a first temperature sensor for measuring a temperature of the first air vent and a second temperature sensor for measuring a temperature of the second air vent; and
when performing the acquiring a temperature of a target position in the network device by using the at least one temperature sensor, the processor is specifically configured to:
respectively acquire a first temperature value of the first air vent of the network device and a second temperature value of the second air vent of the network device by using the first temperature sensor and the second temperature sensor.

8. The network device according to claim 7, wherein when performing the respectively acquiring a first temperature value of the first air vent of the network device and a second temperature value of the second air vent of the network device by using the first temperature sensor and the second temperature sensor, the processor is specifically configured to:
when the rotation direction of the fan enables that cold air is inhaled from the first air vent, and hot air is exhausted from the second air vent, acquire, by using the first temperature sensor, the first temperature value indicated by the first temperature sensor; and
when the rotation direction of the fan enables that cold air is inhaled from the second air vent, and hot air is exhausted from the first air vent, acquire, by using the second temperature sensor, the second temperature value indicated by the second temperature sensor.

9. The network device according to claim 6, wherein the at least one temperature sensor is disposed at the target position in the network device; and
when performing the acquiring a temperature of a target position in the network device by using the at least one temperature sensor, the processor is specifically configured to:
when the rotation direction of the fan enables that cold air is inhaled from the first air vent, and hot air is exhausted from the second air vent, acquire a first temperature value of the network device by using the at least one temperature sensor; and
when the rotation direction of the fan enables that cold air is inhaled from the second air vent, and hot air is exhausted from the first air vent, acquire a second temperature value of the network device by using the at least one temperature sensor.

10. The network device according to any one of claims 7 to 9, wherein when performing the determining, according to the temperature of the target position, that one air duct in the first air duct and the second air duct is a cold air duct, and that the other air duct is a hot air duct, the processor is specifically configured to:
compare the first temperature value with the second temperature value; and
if the first temperature value is less than the second temperature value, determine that the first air duct is a cold air duct, and determining that the second air duct is a hot air duct; or
if the first temperature value is greater than the second temperature value, determine that the second air duct is a cold air duct, and determine that the first air duct is a hot air duct.
